# EUROPÄISCHE PATENTSCHRIFT

(11) **EP 2 560 188 B1**
(45) Veröffentlichungstag und Bekanntmachung des Hinweises auf die Patenterteilung: **22.04.2020**
(21) Anmeldenummer: 12179402.8
(22) Anmeldetag: 06.08.2012
(51) Int. Cl.: H01J 40/02, H01J 43/02, H01J 43/28, H01J 40/16

(54) **Detektorvorrichtung**
Detector device
Dispositif de détection

(30) Priorität: 16.08.2011 DE 102011052738
(43) Veröffentlichungstag der Anmeldung: 20.02.2013
(73) Patentinhaber: Leica Microsystems CMS GmbH, 35578 Wetzlar (DE)
(72) Erfinder: Widzgowski, Bernd, 69221 Dossenheim (DE)
(74) Vertreter: Hoffmann, Jürgen

(56) Entgegenhaltungen:
- EP-A1- 0 595 468
- EP-A1- 1 541 979
- US-A- 3 139 733
- US-A1- 2004 135 071
- US-A1- 2006 140 462
- Motohiro Suyama ET AL: "PHOTOMULTIPLIERS: Hybrid detector combines PMT and semiconductor-diode technologies", Laser Focus World, 1 March 2008 (2008-03-01), pages 1-8, XP055565747, Retrieved from the Internet: URL:https://www.laserfocusworld.com/articl es/2008/03/photomultipliers-hybrid-detecto r-combines-pmt-and-semiconductor-diode-tec hnologies.html [retrieved on 2019-03-07]

## Beschreibung

Die Erfindung betrifft ein Scanmikroskop aufweisend eine Detektorvorrichtung, die dazu ausgebildet ist Licht zu empfangen und elektrische Signale zu erzeugen, mit einem Gehäuse und einem in dem Gehäuse angeordneten Detektor.

US 2006/0140462 A1 offenbart ein Scanmikroskop aus dem Stand der Technik. Detektorvorrichtungen der eingangs genannten Art weisen oft einen temperaturabhängigen Dunkelstrom auf, der Rauschen verursacht. Durch Kühlen kann dieser Dunkelstrom verringert werden.

Aus DE 10 2009 036 066 A1 ist ein optoelektronischer Detektor bekannt, der eine mit dem Detektor wärmeleitend verbundene Kühlvorrichtung, nämlich ein Peltier-Element, aufweist. Zur Vermeidung des Entstehens von Tauwasser auf einer Oberfläche des optoelektronischen Detektors, ist ein Sensor zur Ermittlung eines momentanen Werts bezüglich der Umgebungsluftfeuchte und der Umgebungstaupunkttemperatur vorgesehen. Der Sensor ist mit einer Steuereinheit verbunden, welche die Kühlvorrichtung in Abhängigkeit des Werts steuert. Dieser optoelektronische Detektor hat den Vorteil, dass auf eine Kühlung nicht gänzlich verzichtet ist. Er hat jedoch den Nachteil, das die tatsächliche Kühlleistung auf ein geringes Maß begrenzt ist; nämlich auf das Maß, bei dem kein Tauwasser entsteht. Dies hat im Ergebnis zur Folge, dass ein Detektorrauschen nur unzureichend vermieden ist.

In derselben Druckschrift wird eine andere Detektorvorrichtung erwähnt, bei der Detektor samt der Kühlvorrichtung, typischerweise einem Peltier-Element, in einem luftdichten Gehäuse verkapselt ist, das mit einem getrockneten Gas gefüllt oder evakuiert ist. Die Abwärme der Kühlvorrichtung kann bei dieser Vorrichtung einem Kühlkörper zugeführt werden, der mit der Kühlvorrichtung wärmeleitend verbunden ist und/oder zum Beheizen anderer Bauteile, beispielsweise einem Eintrittsfenster des Gehäuses, verwendet werden. Diese Detektorvorrichtung wird jedoch als nachteilig ausgewiesen, weil die luftdichte Verkapselung aufwendig ist.

Tatsächlich hat sich in der Praxis sogar gezeigt, dass diese Detektorvorrichtung noch weitere Nachteile hat. Insbesondere ist das Kühlen oft nicht sehr effektiv. Darüber hinaus gestaltet sich das Kühlen als besonders schwierig, wenn sich der Detektor auf einem anderen elektrischen Potentialniveau befinden muss, als das Gehäuse. In diesem Fall kann das Peltier-Element nicht einfach zwischen Gehäuse und Detektor angeordnet werden. Eine solche Potentialdifferenz ist zumeist dann notwendig, wenn innerhalb des Detektors eine Beschleunigung von Photoelektronen erfolgen soll.

Es ist die Aufgabe der vorliegenden Erfindung, ein Scanmikroskop aufweisend eine Detektorvorrichtung anzugeben, die ein effizienteres Kühlen, insbesondere auch bei Verwendung von Detektoren, die auf einem anderen elektrischen Potentialniveau liegen, als das Gehäuse, ermöglicht.

Die Aufgabe wird durch ein Scanmikroskop gemäß Anspruch 1 gelöst.

Bei einer ganz besonders vorteilhaften Ausführungsform ist innerhalb des Gehäuses ein weiteres Kühlbauteil vorgesehen. Insbesondere kann vorteilhaft ein weiteres Kühlbauteil vorgesehen sein, das mit dem Kühlbauteil in Wärme leitendem Kontakt steht.

Auch in Bezug auf das weitere Kühlbauteil kann vorteilhaft vorgesehen sein, dass ein Lichtweg für das zu detektierende Licht festgelegt ist, der durch das weitere Kühlbauteil hindurch verläuft.

Um zu ermöglichen, dass ein Lichtweg für das zu detektierende Licht durch das Kühlbauteil und/oder durch das weitere Kühlbauteile hindurch verlaufen kann, kann das Kühlbauteil und/oder das weitere Kühlbauteil einen Durchgang, insbesondere eine Durchgangsbohrung, aufweisen. Es kann jedoch auch vorgesehen sein, dass das Kühlbauteil und/oder das weitere Kühlbauteil zwei- oder mehrteilig aufgebaut ist, wobei die Teile derart zueinander angeordnet sind, dass ein Zwischenraum verbleibt, durch den hindurch der Lichtweg für das detektierende Licht verläuft.

Auch das weitere Kühlbauteil kann vorteilhaft als wärmeleitendes, elektrisch isolierendes Zwischenelement ausgebildet sein. Insbesondere kann, was im Detail im Folgenden noch beschrieben wird, das weitere Kühlbauteil als passives Kühlbauteil, insbesondere als wärmeableitender Ring, ausgebildet sein, der zwischen dem Detektor und einem aktiven Kühlbauteil, bspw. einen Peltier-Element, angeordnet ist.

Auch das weitere Kühlbauteil kann bei einer vorteilhaften Ausführung derart angeordnet sein, dass es in unmittelbarem Kontakt zu einem Lichtsensor des Detektors, bspw. einer Photokatode, steht. Es kann - alternativ oder zusätzlich - auch vorgesehen sein, dass das weitere Kühlbauteil in unmittelbarem Kontakt zu einem Substrat steht, das einen Lichtsensor, bspw. eine Photokatode, trägt.

Durch den unmittelbaren Kontakt des Kühlbauteils und/oder des weiteren Kühlbauteils zu einem Lichtsensor des Detektors und/oder zu einem Substrat, das einen Lichtsensor trägt, wird eine besonders effektive Kühlung erreicht. Insbesondere hat eine solche Ausführung den Vorteil, dass lediglich die Bauteile gekühlt werden, die tatsächlich ein temparaturabhängiges Rauschverhalten zeigen.

Darüber hinaus ist bei einer solchen Ausführung vorteilhafter Weise eine wesentlich geringere Kühlleistung erforderlich, was insbesondere von Vorteil ist, wenn das Kühlbauteil und/oder das weitere Kühlbauteil als aktives Kühlbauteil, bspw. als Peltier-Element, ausgebildet ist. In dem Fall, dass das Kühlbauteil und/oder das weitere Kühlbauteil als aktives Kühlbauteil ausgebildet ist, fällt in vorteilhafter Weise daher auch weniger Abwärme an, die nach außen transportiert werden muss.

Wie bereits erwähnt, kann das Kühlbauteil und/oder das weitere Kühlbauteil vorteilhaft als aktives Kühlbauteil, insbesondere als Peltier-Element oder als Wärmepumpe oder als Heat-Pipe ausgebildet sein. Bei einer ganz besonders vorteilhaften Ausführung ist das Kühlbauteil als ringförmiges Peltier-Element ausgebildet. Eine solche Ausführung bietet den Vorteil, dass durch die Ringmitte der Lichtweg für das zu detektierende Licht verlaufen kann, so dass der Lichtweg beim Durchtritt durch das ringförmige Peltier-Element im Wesentlichen koaxial zur Rotationssymmetrieachse des ringförmigen Peltier-Elements angeordnet ist.

Bei einer ganz besonders vorteilhaften Ausführung ist das Kühlbauteil und/oder das weitere Kühlbauteil derart angeordnet, dass die Abwärme des Kühlbauteils und/oder des weiteren Kühlbauteils wenigstens ein Eintrittsfenster des Gehäuses und/oder eine Eintrittsoptik des Gehäuses erwärmt. Eine solche Ausführung hat den ganz besonderen Vorteil, dass sich auf den Oberflächen des Eintrittsfensters bzw. auf den Oberflächen der Eintrittsoptik, bspw. eine Linse oder eine Anordnung mehrerer Linsen, kein Tauwasser absetzt. Dies ist insbesondere dann gewährleistet, wenn unter Ausnutzung der Abwärme die Temperatur der Oberflächen des Eintrittsfensters bzw. der Optik oberhalb des Taupunktes gehalten wird.

In besonders vorteilhafter Weise kann vorgesehen sein, dass das Kühlbauteil und/oder das weitere Kühlbauteil als passives Kühlbauteil ausgebildet ist, durch das hindurch ein Wärmestrom stattfindet. Von besonderem Vorteil ist es, wenn das passive Kühlbauteil und/oder das weitere passive Kühlbauteil eine gute Wärmeleitfähigkeit aufweist, um einen schnellen Wärmetransport zu gewährleisten. Insoweit kann vorteilhaft vorgesehen sein, dass das Kühlbauteil und/oder das weitere Kühlbauteil eine Wärmeleitfähigkeit größer 1 W/mK, insbesondere größer 10 W/mK, insbesondere größer 100 W/mK, ganz insbesondere größer 500 W/mK aufweist.

Bei einer ganz besonders vorteilhaften Ausführung ist das passive Kühlbauteil und/oder das weitere passive Kühlbauteil derart geformt und dimensioniert, dass es sich passgenau und möglichst großflächig an das zu kühlende Bauteil der Detektorvorrichtung, insbesondere an einen Lichtsensor und/oder an ein lichtsensortragendes Substrat, anschmiegen kann. Hierdurch ist eine besonders gute Kühlung erreichbar. Gleiches gilt in analoger Weise auch für den Fall, dass das Kühlbauteil als aktives Kühlbauteil ausgebildet ist und/oder das das weitere Kühlbauteil als aktives weiteres Kühlbauteil ausgebildet ist. Die Ausformung des Kühlbauteils bzw. des weiteren Kühlbauteils erfolgt jedoch vorzugsweise stets derart, dass die Funktion des Detektors und/oder die Funktion von Teilen des Detektors nicht nachteilig, bspw. durch Abschattung eines Lichtweges, beeinträchtigt wird.

Bei einer ganz besonders vorteilhaften Ausführung, die insbesondere dann einsetzbar ist, wenn der Detektor und/oder Teile des Detektors auf einem anderen elektrischen Potentialniveau liegen, als das Gehäuse, ist das Kühlbauteil und/oder das weitere Kühlbauteil elektrisch weitgehend isolierend ausgebildet. Insbesondere kann vorgesehen sein, dass das Kühlbauteil und/oder das weitere Kühlbauteil eine elektrische Leitfähigkeit kleiner als 10⁻⁷ S/m, insbesondere kleiner als 10⁻⁸ S/m aufweist.

Eine solche Ausführung hat den ganz besonderen Vorteil, dass der Detektor über das Kühlbauteil bzw. das weitere Kühlbauteil in mechanischem Kontakt zum Gehäuse stehen kann, während der Detektor dennoch elektrisch zumindest soweit isoliert ist, dass er auf dem erforderlichen Potentialniveau betrieben werden kann. Beispielsweise kann vorgesehen sein, dass der Detektor eine Beschleunigungsvorrichtung zum Beschleunigen von mittels einer Photokathode erzeugter Elektronen aufweist, wobei die beschleunigten Elektronen einer Avalanchediode zugeleitet werden. Insoweit kann es vorkommen, dass zwischen dem Detektor oder Teilen des Detektors und dem Gehäuse eine elektrische Spannungsdifferenz von mehreren 1000 Volt anliegen muss.

Insbesondere um solchen Spannungsdifferenzen standhalten zu können, ist bei einer besonderen Ausführungsform des Detektors vorgesehen, dass das Kühlbauteil und/oder das weitere Kühlbauteil zumindest teilweise aus einem elektrisch isolierenden und thermisch leitenden Material, insbesondere aus Bornitrid, Aluminiumnitrid, Aluminiumoxid, Diamant, synthetischem Diamant oder einer Kombination aus diesen Materialien besteht. Diese Stoffe zeichnen sich einerseits durch eine hohe Wärmeleitfähigkeit und andererseits durch eine sehr geringe elektrische Leitfähigkeit aus. Darüber hinaus bieten diese Materialien den Vorteil, dass sie, bspw. durch Schleifen, Drehen oder Fräsen, einfach und genau bearbeitbar sind.

Bei einer ganz besonderen Ausführungsform ist vorgesehen, dass das Kühlbauteil und/oder das weitere Kühlbauteil, insbesondere zur Erhöhung der Kriechstromfestigkeit, wenigstens einen umlaufenden Vorsprung oder wenigstens eine umlaufende Nut aufweist. Eine solche Ausführung hat den besondern Vorteil, dass der Kriechweg entlang der Oberfläche des Kühlbauteils bzw. des weiteren Kühlbauteils verlängert wird, so dass die Gefahr eines elektrischen Überschlags zumindest vermindert ist.

In vorteilhafter Weise kann das Kühlbauteil und/oder das weitere Kühlbauteil im Wesentlichen ringförmig oder zylinderförmig ausgebildet sein. Wie bereits erwähnt, bietet dies sowohl besondere Vorteile im Hinblick darauf, das Kühlbauteil bzw. das weitere Kühlbauteil für eine effektive Kühlung günstig, bspw. in Kontakt zu einem Lichtsensor oder einem einen lichtsensortragenden Substrat, zu bringen und andererseits den weiteren Vorteil, dass ein Durchbruch für den Lichtweg des zu detektierenden Lichts besteht.

Bei einer besonders effektiv und zuverlässig arbeitenden Ausführungsform sind das Kühlbauteil und das weitere Kühlbauteil thermisch in Reihe geschaltet. Insbesondere kann ganz besonders vorteilhaft vorgesehen sein, dass das Kühlbauteil als passives Kühlbauteil, bspw. als Bornitridring, ausgebildet ist und in unmittelbarem Kontakt zu einem Lichtsensor und/oder zu einem lichtsensortragenden Substrat steht.

Darüber hinaus kann vorteilhaft vorgesehen sein, dass dieses Kühlbauteil mit einem weiteren Kühlbauteil thermisch in Kontakt steht, das als aktives Kühlbauteil, bspw. als ringförmiges Peltier-Element ausgebildet ist.

Vorzugsweise sind das ringförmige Kühlbauteil und das ringförmige weitere Kühlbauteil koaxial zueinander angeordnet, wobei der Lichtweg für das zu detektierende Licht entlang der Rotationssymmetrieachse des Kühlbauteils und des weiteren Kühlbauteils verläuft. Darüber hinaus kann in vorteilhafter Weise vorgesehen sein, dass das weitere, aktive Kühlbauteil, bspw. die heiße Seite eines Peltier-Elements, in Kontakt zu einem Eintrittsfenster oder einer Eintrittsoptik des Gehäuses steht. Eine solche Anordnung zeichnet sich dadurch aus, dass ein Lichtsensor des Detektors besonders effektiv gekühlt werden kann, weil ein direkter Wärmetransport von dem Lichtsensor bzw. seinem Substrat über das passive Kühlbauteil zu dem aktiven Kühlbauteil erfolgt. Darüber hinaus wird in vorteilhafter Weise die Abwärme des aktiven Kühlbauteils zur Vermeidung des Entstehens von Tauwasser auf dem Eintrittsfenster bzw. der Eintrittsoptik verwendet. Wenn bei dieser Anordnung als Kühlbauteil ein elektrisch weitgehend isolierendes Material eingesetzt wird, bspw. Bornitrid, so ist es in sehr vorteilhafter Weise ermöglicht, den Detektor auf einem Potentialniveau zu betreiben, das sich vom Potentialniveau des Gehäuses unterscheidet.

Insbesondere zur Vermeidung des Entstehens von Tauwasser kann vorteilhaft vorgesehen sein, dass das Gehäuse gasdicht ist und/oder das in dem Gehäuse ein Vakuum vorliegt. Bspw. kann auch vorgesehen sein, dass das gasdichte Gehäuse mit einem Gas, vorzugsweise einem getrockneten Gas, gefüllt wird, dessen Taupunkt besonders niedrig liegt. Beispielsweise kann es vorteilhaft sein, ein Trocknungsmittel in das Gehäuse einzubringen. Dieses dient dazu, eventuell noch vorhandene Restfeuchte zu entfernen oder eindringende Feuchtigkeit zu absorbieren.

Ganz besonders vorteilhaft lässt sich die erfindungsgemäße Detektorvorrichtung mit oder in einem konfokalen Scanmikroskop einsetzen. Bei einer ganz besonders vorteilhaften Ausführung eines konfokalen Scanmikroskopes weist dieses mehrere der erfindungsgemäßen Detektorvorrichtungen auf. Bspw. kann vorgesehen sein, dass den einzelnen Detektorvorrichtungen unterschiedliche Detektionsspektralbereiche zugeordnet sind und/oder zuordenbar sind.

Weitere Ziele, Vorteile, Merkmale und Anwendungsmöglichkeiten der vorliegenden Erfindung ergeben sich aus der nachfolgenden Beschreibung eines Ausführungsbeispieles anhand der Zeichnung.

Es zeigen:
- Fig. 1: schematisch eine erfindungsgemäße Detektorvorrichtung und
- Fig. 2: schematisch eine andere erfindungsgemäße Detektorvorrichtung.

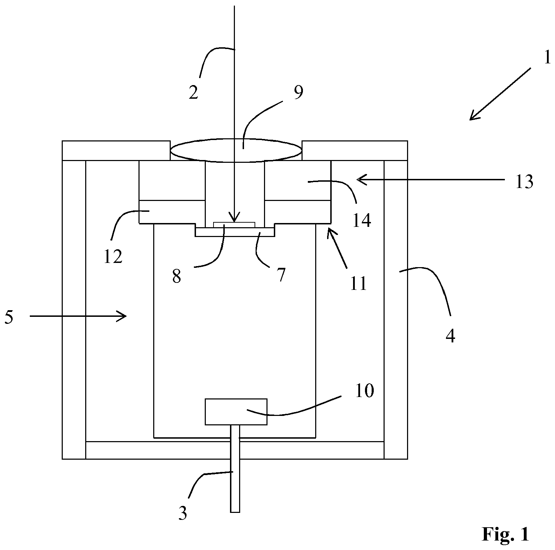

Figur 1 zeigt eine Detektorvorrichtung 1, die dazu ausgebildet ist, Licht 2 zu empfangen und an einem elektrischen Ausgang 3 elektrische Signale bereitzustellen. Die Detektorvorrichtung 1 weist ein Gehäuse 4 auf, in dem ein Detektor 5 angeordnet ist.

Der Detektor 5 weist einen Lichtsensor 6, nämlich eine auf einem Substrat 7 angeordnete Photokathode 8 auf, die in Transmissionsanordnung betrieben wird. Dies bedeutet, dass die Photokathode 8 auf ihrer einer Eintrittsoptik 9 des Gehäuses 4 zugewandten Seite das zu detektierende Licht 2 empfängt und auf der von dieser abgewandten Seite Fotoelektronen abgibt.

Die Photokathode 8 und ihr Substrat 7 liegen auf einem Potentialniveau von - 8000 V, während das Gehäuse 4 auf einem Potentialniveau von 0 V liegt.

Der Detektor 5 weist darüber hinaus eine Avalanchediode 10 auf, die auf einem Potentialniveau von - 400 V liegt. Die von der Photokathode 8 erzeugten Fotoelektronen werden auf Grund der zwischen der Photokathode 8 und der Avalanchediode10 bestehenden Potentialdifferenz beschleunigt und treffen auf eine Avalanchediode10, die elektrische Signale über den elektrischen Ausgang 3 ausgibt.

Die Detektorvorrichtung 1 weist innerhalb des Gehäuses 4 ein Kühlbauteil 11 auf, das als passives Kühlbauteil ausgebildet ist. Konkret ist das Kühlbauteil 11 als wärmeleitendes, elektrisch isolierendes Zwischenelement 12 ausgebildet. Das Zwischenelement 12 weist eine ringförmige Form auf, wobei die Mittelachse des Zwischenelements koaxial zum Lichtweg des zu detektierenden Lichts 2 verläuft.

Die Detektorvorrichtung 1 weist darüber hinaus innerhalb des Gehäuses 4 ein weiteres Kühlbauteil 13 auf, das als ringförmiges Peltier-Element 14 ausgebildet ist. Das ringförmige Peltier-Element 14 ist koaxial zu dem ringförmigen Zwischenelement 12 angeordnet.

Das ringförmige Peltier-Element 14 steht in wärmeleitendem Kontakt zu dem Zwischenelement 12. Das Zwischenelement 12 steht in wärmeleitendem Kontakt zum Substrat 7.

Über das wärmeleitende, elektrisch isolierende Zwischenelement 12 kann die Kühlleistung zur Kühlung des Substrats 7 und der Photokathode 8 besonders effektiv genutzt werden. Darüber hinaus ist vorgesehen, dass die warme Seite des ringförmigen Peltier-Elements 14 dem Gehäuse 4 und der Eintrittsoptik 9 zugewandt ist. Hierdurch wird die Eintrittsoptik 9 neu erwärmt, so dass sich kein Tauwasser niederschlagen kann. Der übrige Zwischenraum zwischen dem Detektor 5, dem Zwischenelement 12 und dem ringförmigen Peltier-Element 14 zu dem Gehäuse 4 ist mit einer thermisch und elektrisch isolierenden Vergussmasse gefüllt. Der Bereich zwischen der Eintrittsoptik 9 und der Photokathode 8 ist mit einem getrockneten Gas gefüllt.

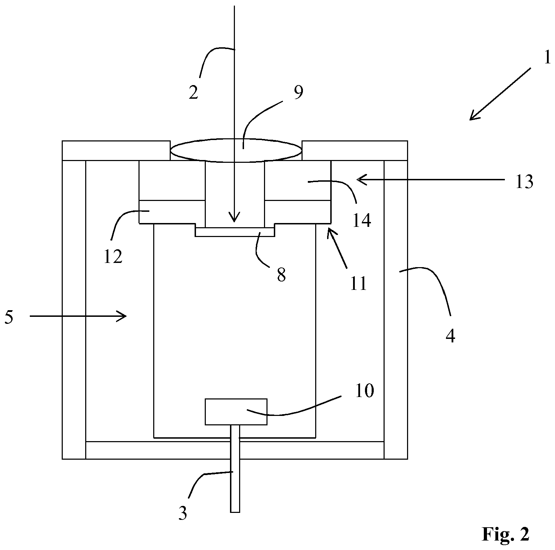

Figur 2 zeigt eine andere Detektorvorrichtung, bei der das Zwischenelement 12 in unmittelbarem, wärmeleitenden Kontakt zur Photokathode 8 steht.

### Bezugszeichenliste

- 1: Detektorvorrichtung
- 2: zu detektierendes Licht
- 3: elektrischer Ausgang
- 4: Gehäuse
- 5: Detektor
- 6: Lichtsensor
- 7: Substrat
- 8: Photokathode
- 9: Eintrittsoptik
- 10: Avalanchediode
- 11: Kühlbauteil
- 12: Zwischenelement
- 13: Weiteres Kühlbauteil
- 14: Peltier-Element

## Patentansprüche

1. Scanmikroskop aufweisend eine Detektorvorrichtung (1), die dazu ausgebildet ist Licht (2) zu empfangen und elektrische Signale zu erzeugen, mit einem Gehäuse (4) und einem in dem Gehäuse (4) angeordneten Detektor (5), wobei
a. innerhalb des Gehäuses (4) ein Kühlbauteil (11) angeordnet ist und dass ein Lichtweg für das zu detektierende Licht (2) festgelegt ist, der durch das Kühlbauteil (11) hindurch verläuft und/oder wobei
b. innerhalb des Gehäuses (4) ein Kühlbauteil (11) angeordnet ist, das als wärmeleitendes, elektrisch isolierendes Zwischenelement (12) ausgebildet ist,
wobei die Detektorvorrichtung (1) einen Lichtsensor (6), insbesondere eine Photokathode (8), aufweist, dem ein Elektronenbeschleuniger nachgeschaltet ist, wobei die beschleunigten Elektronen einer Avalanchediode (10) zugeleitet werden.

2. Scanmikroskop nach Anspruch 1, **dadurch gekennzeichnet, dass** innerhalb des Gehäuses (4) ein weiteres Kühlbauteil (13) vorgesehen ist und/oder dass ein weiteres Kühlbauteil (13) vorgesehen ist, das mit dem Kühlbauteil (11) in wärmeleitendem Kontakt steht.

3. Scanmikroskop nach Anspruch 2, **dadurch gekennzeichnet, dass**
a. ein Lichtweg für das zu detektierende Licht (2) festgelegt ist, der durch das weitere Kühlbauteil (13) hindurch verläuft und/oder dass
b. das weitere Kühlbauteil (13) als wärmeleitendes, elektrisch isolierendes Zwischenelement (12) ausgebildet ist und/oder dass
c. das weitere Kühlbauteil (13) in unmittelbarem Kontakt zu einem Lichtsensor (6) des Detektors (5), insbesondere einer Photokathode (8), und/oder in unmittelbaren Kontakt zu einem einen Lichtsensor (6), insbesondere eine Photokathode (8), tragenden Substrat (7) steht.

4. Scanmikroskop nach einem der Ansprüche 1 bis 3, **dadurch gekennzeichnet, dass**
a. das Kühlbauteil (11) und/oder das weitere Kühlbauteil (13) als aktives Kühlbauteil (11), insbesondere als Peltier-Element (14) oder als Wärmepumpe oder als Heat-Pipe, ausgebildet ist oder dass
b. das Kühlbauteil (11) und/oder das weitere Kühlbauteil (13) als aktives Kühlbauteil, insbesondere als Peltier-Element (14) oder als Wärmepumpe oder als Heat-Pipe, ausgebildet ist und dass das Kühlbauteil (11) und/oder das weitere Kühlbauteil (13) derart angeordnet ist, dass die Abwärme des Kühlbauteils (11) und/oder des weiteren Kühlbauteils(13) wenigstens ein Eintrittsfenster des Gehäuses (4) und/oder eine Eintrittsoptik (9) des Gehäuses (4) erwärmt.

5. Scanmikroskop nach Anspruch 1 bis 3, **dadurch gekennzeichnet, dass** das Kühlbauteil (11) und/oder das weitere Kühlbauteil (13) als passives Kühlbauteil ausgebildet ist, durch das hindurch ein Wärmestrom stattfindet.

6. Scanmikroskop nach Anspruch 5, **dadurch gekennzeichnet, dass** das das Kühlbauteil (11) und/oder das weitere Kühlbauteil (13) zumindest teilweise aus einem elektrisch isolierenden und thermisch leitenden Material, insbesondere aus Bornitrid, Aluminiumnitrid, Aluminiumoxid, Diamant, synthetischem Diamant oder einer Kombination aus diesen Materialien, besteht.

7. Scanmikroskop nach Anspruch 5 oder 6, **dadurch gekennzeichnet, dass** das das Kühlbauteil (11) und/oder das weitere Kühlbauteil (13) eine Wärmeleitfähigkeit größer 1 W/mK, insbesondere größer 10 W/mK, insb. größer als 100 W/mK, insbesondere größer 500 W/mK aufweist.

8. Scanmikroskop nach einem der Ansprüche 5 bis 7, **dadurch gekennzeichnet, dass** das Kühlbauteil (11) und/oder das weitere Kühlbauteil (13) eine elektrische Leitfähigkeit kleiner als 10⁻⁷ S/m, insbesondere kleiner als 10⁻⁸ S/m, aufweist.

9. Scanmikroskop nach einem der Ansprüche 1 bis 8, **dadurch gekennzeichnet, dass** das Kühlbauteil (11) und/oder das weitere Kühlbauteil (13), insbesondere zur Erhöhung der Kriechstromfestigkeit, wenigstens einen umlaufenden Vorsprung und/oder wenigstens eine umlaufende Nut aufweist.

10. Scanmikroskop nach einem der Ansprüche 1 bis 9, **dadurch gekennzeichnet, dass** das Kühlbauteil (11) und/oder das weitere Kühlbauteil (13) im Wesentlichen ringförmig oder zylinderförmig ausgebildet ist.

11. Scanmikroskop nach einem der Ansprüche 2 bis 10, **dadurch gekennzeichnet, dass** das Kühlbauteil (11) und das weitere Kühlbauteil (13) thermisch in Reihe geschaltet sind.

12. Scanmikroskop nach einem der Ansprüche 1 bis 11, **dadurch gekennzeichnet, dass** das Gehäuse (4) gasdicht ist und/oder dass in dem Gehäuse (4) ein Vakuum vorliegt.

13. Scanmikroskop nach einem der Ansprüche 1 bis 12, **dadurch gekennzeichnet, dass** zwischen dem Detektor (5) und dem Gehäuse (4) eine elektrische Potentialdifferenz vorliegt.

## Claims

1. Scanning microscope, having a detector apparatus (1), which is configured to receive light (2) and to generate electrical signals, with a housing (4) and a detector (5) arranged in the housing (4), wherein
a. a cooling component (11) is arranged in the housing (4) and a light path for the light (2) to be detected is defined and passes through the cooling component (11) and/or wherein
b. a cooling component (11) is provided in the housing (4) and is embodied in the form of a thermally conducting, electrically insulating intermediate element (12),
wherein the detector apparatus (1) has a light sensor (6), in particular a photo cathode (8), connected downstream of which is an electron accelerator, wherein the accelerated electrons are guided to an avalanche diode (10).

2. Scanning microscope according to Claim 1, **characterized in that** a further cooling component (13) is provided in the housing (4) and/or that a further cooling component (13) which is in heat-conducting contact with the cooling component (11) is provided.

3. Scanning microscope according to Claim 2, **characterized in that**
a. a light path for the light (2) to be detected is defined and passes through the further cooling component (13) and/or **in that**
b. the further cooling component (13) is embodied in the form of a heat-conducting, electrically insulating intermediate element (12) and/or **in that**
c. the further cooling component (13) is in immediate contact with a light sensor (6) of the detector (5), in particular a photo cathode (8), and/or is in immediate contact with a substrate (7) carrying a light sensor (6), in particular a photo cathode (8).

4. Scanning microscope according to one of Claims 1 to 3, **characterized in that**
a. the cooling component (11) and/or the further cooling component (13) is embodied in the form of an active cooling component (11), in particular a Peltier element (14) or a heat pump or a heat pipe, or **in that**
b. the cooling component (11) and/or the further cooling component (13) is embodied in the form of an active cooling component, in particular a Peltier element (14) or a heat pump or a heat pipe, and **in that** the cooling component (11) and/or the further cooling component (13) is arranged such that the waste heat of the cooling component (11) and/or of the further cooling component (13) heats at least one entrance window of the housing (4) and/or an entrance optical unit (9) of the housing (4).

5. Scanning microscope according to one of Claims 1 to 3, **characterized in that** the cooling component (11) and/or the further cooling component (13) is embodied in the form of a passive cooling component through which heat flows.

6. Scanning microscope according to Claim 5, **characterized in that** the cooling component (11) and/or the further cooling component (13) consists at least partially of an electrically insulating and thermally conducting material, in particular of boron nitride, aluminium nitride, aluminium oxide, diamond, synthetic diamond or a combination of these materials.

7. Scanning microscope according to Claim 5 or 6, **characterized in that** the cooling component (11) and/or the further cooling component (13) has a thermal conductivity of greater than 1 W/mK, in particular greater than 10 W/mK, in particular greater than 100 W/mK, in particular greater than 500 W/mK.

8. Scanning microscope according to one of Claims 5 to 7, **characterized in that** the cooling component (11) and/or the further cooling component (13) has an electric conductivity of less than 10⁻⁷ S/m, in particular less than 10⁻⁸ S/m.

9. Scanning microscope according to one of Claims 1 to 8, **characterized in that** the cooling component (11) and/or the further cooling component (13) has at least one circumferential projection and/or at least one circumferential groove, in particular to increase the tracking resistance.

10. Scanning microscope according to one of Claims 1 to 9, **characterized in that** the cooling component (11) and/or the further cooling component (13) is embodied to be substantially ring-shaped or cylindrical.

11. Scanning microscope according to one of Claims 2 to 10, **characterized in that** the cooling component (11) and the further cooling component (13) are thermally connected in series.

12. Scanning microscope according to one of Claims 1 to 11, **characterized in that** the housing (4) is gastight and/or **in that** a vacuum prevails in the housing (4) .

13. Scanning microscope according to one of Claims 1 to 12, **characterized in that** an electric potential difference is present between the detector (5) and the housing (4).

## Revendications

1. Microscope à balayage, comprenant un dispositif de détection (1) qui est conçu pour recevoir de la lumière (2) et générer des signaux électriques, comprenant un boîtier (4) et un détecteur (5) disposé dans le boîtier (4),
a. un élément structural de refroidissement (11) étant disposé à l'intérieur du boîtier (4), et un trajet de lumière pour la lumière (2) à détecter étant fixé, lequel suit un tracé à travers l'élément structural de refroidissement (11) et/ou
b. un élément structural de refroidissement (11) étant disposé à l'intérieur du boîtier (4), lequel est réalisé sous la forme d'un élément intermédiaire (12) thermoconducteur électriquement isolant, le dispositif de détection (1) possédant un capteur de lumière (6), notamment une photocathode (8), à la suite duquel est monté un accélérateur d'électrons, les électrons accélérés étant acheminés à une diode à avalanche (10).

2. Microscope à balayage selon la revendication 1, **caractérisé en ce qu'**un élément structural de refroidissement supplémentaire (13) se trouve à l'intérieur du boîtier (4) et/ou **en ce qu'**un élément structural de refroidissement supplémentaire (13) est présent, lequel se trouve en contact thermoconducteur avec l'élément structural de refroidissement (11).

3. Microscope à balayage selon la revendication 2, **caractérisé en ce que**
a. un trajet de lumière pour la lumière (2) à détecter est fixé, lequel suit un tracé à travers l'élément structural de refroidissement supplémentaire (13) et/ou **en ce que**
b. l'élément structural de refroidissement supplémentaire (13) est réalisé sous la forme d'un élément intermédiaire (12) thermoconducteur électriquement isolant et/ou **en ce que**
c. l'élément structural de refroidissement supplémentaire (13) se trouve en contact direct avec un capteur de lumière (6) du détecteur (5), notamment une photocathode (8), et/ou en contact direct avec un substrat (7) qui porte un capteur de lumière (6), notamment une photocathode (8).

4. Microscope à balayage selon l'une des revendications 1 à 3, **caractérisé en ce que**
a. l'élément structural de refroidissement (11) et/ou l'élément structural de refroidissement supplémentaire (13) est réalisé sous la forme d'un élément structural de refroidissement (11) actif, notamment sous la forme d'un élément de Peltier (14) ou d'une pompe à chaleur ou d'un caloduc ou **en ce que**
b. l'élément structural de refroidissement (11) et/ou l'élément structural de refroidissement supplémentaire (13) est réalisé sous la forme d'un élément structural de refroidissement actif, notamment sous la forme d'un élément de Peltier (14) ou d'une pompe à chaleur ou d'un caloduc et/ou **en ce que** l'élément structural de refroidissement (11) et/ou l'élément structural de refroidissement supplémentaire (13) est disposé de telle sorte que la chaleur dissipée de l'élément structural de refroidissement (11) et/ou de l'élément structural de refroidissement supplémentaire (13) chauffe au moins une fenêtre d'entrée du boîtier (4) et/ou une optique d'entrée (9) du boîtier (4).

5. Microscope à balayage selon l'une des revendications 1 à 3, **caractérisé en ce que** l'élément structural de refroidissement (11) et/ou l'élément structural de refroidissement supplémentaire (13) est réalisé sous la forme d'un élément structural de refroidissement à travers lequel se produit un flux de chaleur.

6. Microscope à balayage selon la revendication 5, **caractérisé en ce que** l'élément structural de refroidissement (11) et/ou l'élément structural de refroidissement supplémentaire (13) se compose au moins partiellement d'un matériau électriquement isolant et thermoconducteur, notamment de nitrure de bore, de nitrure d'aluminium, d'oxyde d'aluminium, de diamant, de diamant synthétique ou d'une combinaison de ces matériaux.

7. Microscope à balayage selon la revendication 5 ou 6, **caractérisé en ce que** l'élément structural de refroidissement (11) et/ou l'élément structural de refroidissement supplémentaire (13) présente une conductibilité thermique supérieure à 1 W/mK, notamment supérieure à 10 M/mK, notamment supérieure à 100 W/mK, en particulier supérieure à 500 W/mK.

8. Microscope à balayage selon l'une des revendications 5 à 7, **caractérisé en ce que** l'élément structural de refroidissement (11) et/ou l'élément structural de refroidissement supplémentaire (13) présente une conductivité électrique inférieure à 10⁻⁷ S/m, notamment inférieure à 10⁻⁸ S/m.

9. Microscope à balayage selon l'une des revendications 1 à 8, **caractérisé en ce que** l'élément structural de refroidissement (11) et/ou l'élément structural de refroidissement supplémentaire (13) possède au moins une partie saillante circonférentielle et/ou au moins une rainure circonférentielle, notamment en vue d'augmenter la résistance au courant de fuite.

10. Microscope à balayage selon l'une des revendications 1 à 9, **caractérisé en ce que** l'élément structural de refroidissement (11) et/ou l'élément structural de refroidissement supplémentaire (13) est sensiblement configuré en forme d'anneau ou en forme de cylindre.

11. Microscope à balayage selon l'une des revendications 2 à 10, **caractérisé en ce que** l'élément structural de refroidissement (11) et l'élément structural de refroidissement supplémentaire (13) sont montés thermiquement en série.

12. Microscope à balayage selon l'une des revendications 1 à 11, **caractérisé en ce que** le boîtier (4) est hermétique au gaz et/ou **en ce qu'**un vide est présent dans le boîtier (4).

13. Microscope à balayage selon l'une des revendications 1 à 12, **caractérisé en ce qu'**une différence de potentiel électrique est présente entre le détecteur (5) et le boîtier (4).
